# EUROPEAN PATENT APPLICATION

(11) **EP 0 949 779 A2**
(43) Date of publication of application: **13.10.1999**
(21) Application number: 99302643.4
(22) Date of filing: 01.04.1999
(51) Int. Cl.: H04L 1/00

(54) **Encoding methods and apparatus**

(30) Priority: 06.04.1998 CA 2234008
(71) Applicant: NORTEL NETWORKS CORPORATION, Montreal, Quebec H2Y 3Y4 (CA)
(72) Inventor: Tong, Wen, Ottawa, Ontario K2C 3L7 (CA); Wang, Rui, Ottawa, Ontario K2C 3L6 (CA); Kreindeline, Vitali B., g. Moskva ul. 109518 (RU); Bakouline, Mikhail G., Moskovskaja Oblast 142110 (RU); Chloma, Alexandre M., Koskovskaja Oblast 140160 (RU); Shinakov, Yuri S., Moscow 117574 (RU)
(74) Representative: Humphrey-Evans, Edward John

(57) **Abstract**

An encoder for a communications system comprises a convolutional coder (20), followed by a block interleaver (22), followed by a second coder (24) which is a systematic encoder producing both systematic information (x1, x2) corresponding to the interleaved information (u1, u2) supplied to the input of this coder and parity information (x3) produced therefrom by encoding in accordance with Ungerboeck generator polynomials. The second coder can be a rate 2/3 coder, producing one parity bit for every two bits of systematic information, and a following modulator (26) is conveniently an 8-PSK (phase shift keying) modulator producing one modulation symbol for every two systematic bits and associated one parity bit. A complementary demodulating and decoding arrangement is also described.

## Description

This invention relates to encoding methods and apparatus. The terms "encoding" and "decoding" are used herein to embrace not only the functions of encoding and decoding but also, where applicable, the functions of modulation and demodulation.

### Background

A class of parallel concatenated convolutional codes, also known as PCCCs or turbo codes, is known for example from an article by C. Berrou et al. entitled "Near Shannon Limit Error-Correcting Coding And Decoding: Turbo-Codes", Proceedings of the IEEE International Conference on Communications, 1993, pages 1064-1070. A turbo code encoder provides a parallel concatenation of typically two identical RSC (Recursive Systematic Convolutional) codes applied to an input bit sequence and an interleaved version of this input bit sequence. The output of the encoder comprises systematic bits (the input bit sequence itself) and parity bits which can be selected or "punctured" to provide a desired rate of encoding. Decoding is performed in an iterative manner using feedback of extrinsic information.

It is known to provide in a communications system, for example in a mobile or fixed wireless communications system which may use TDMA or CDMA communications, an encoding and modulation arrangement in which a signal is convolutionally coded, interleaved, and modulated for example using PSK (phase shift keying) techniques such as BPSK (binary PSK), QPSK (quadrature PSK), or DQPSK (differential QPSK). An article by A. Picart et al. entitled "Turbo-Detection: A New Approach to Combat Frequency Selectivity", Proceedings of the IEEE International Conference on Communications, 1997, pages 1498-1502 applies iterative decoding to the detection and decoding of signals in such a system. An article by R. Herzog et al. entitled "Iterative Decoding and Despreading improves CDMA-Systems using M-ary Orthogonal Modulation and FEC", Proceedings of the IEEE International Conference on Communications, 1997, pages 909-913 describes a serial "turbo"-decoding scheme similar to the parallel scheme described in the Berrou article referred to above. The Herzog article applies this iterative decoding scheme to coherent and non-coherent receivers in a CDMA communications system.

Although such iterative decoding schemes can provide advantages in terms of improved detection performance with conventional encoding and modulation arrangements, they do not provide the advantages of parallel concatenation convolutional coding at the transmitter.

An object of this invention is to provide improved encoding methods and apparatus, which can facilitate the decoding of signals using turbo detection principles..

### Summary of the Invention

One aspect of this invention provides a method of encoding information comprising the steps of: encoding the information in a first coder to produce encoded information; and interleaving blocks of the encoded information to produce interleaved encoded information; characterized by: encoding the interleaved encoded information in a second coder to produce further encoded information comprising systematic information, corresponding to the interleaved encoded information, and parity information produced by the second coder in response to the interleaved encoded information.

The encoding in the first coder can comprise convolutional encoding. The parity information can be produced by the second coder using Ungerboeck generator polynomials, for example producing one additional parity bit for every two bits of the interleaved encoded information, constituting said systematic information. The method can include the step of modulating the systematic and parity information produced by the second coder, for example comprising 8-PSK (phase shift keying) modulation, each modulation symbol comprising said one parity bit and two bits constituting said systematic information.

Another aspect of the invention provides encoding apparatus comprising: a first coder for encoding information to produce encoded information; and an interleaver, having an input coupled to an output of the first coder, for interleaving blocks of the encoded information to produce interleaved encoded information; characterized by: a second coder, having an input coupled to an output of the interleaver, for encoding the interleaved encoded information to produce further encoded information comprising systematic information constituted by the interleaved encoded information and parity information produced by the second coder in response to the interleaved encoded information.

The first coder can comprise a convolutional coder. The second coder can comprise a convolutional coder using Ungerboeck generator polynomials to produce said parity information; for example the second coder can be a rate 2/3 coder producing one parity bit for every two bits of systematic information. The apparatus can include a modulator, for example an 8-PSK (phase shift keying) modulator, having an input coupled to an output of the second coder, for modulating the systematic and parity information produced by the second coder.

The invention also provides decoding apparatus for decoding information encoded by the above method or encoding apparatus, comprising first and second soft decision decoders complementary to the first and second coders, having forward and feedback paths between the decoders for iterative decoding thereby, one of the forward and feedback paths including an interleaver and the other of the forward and feedback paths including a complementary deinterleaver. The encoding and/or decoding apparatus can be implemented by functions of a digital signal processor.

### Brief Description of the Drawings

The invention will be further understood from the following description with reference to the accompanying drawings, in which:
Fig. 1 illustrates a known encoding and modulating arrangement;
Fig. 2 illustrates an encoding and modulating arrangement in accordance with an embodiment of this invention;
Fig. 3 illustrates a form of an encoder of the arrangement of Fig. 2; and
Fig. 4 illustrates a complementary demodulating and decoding arrangement.

### Detailed Description

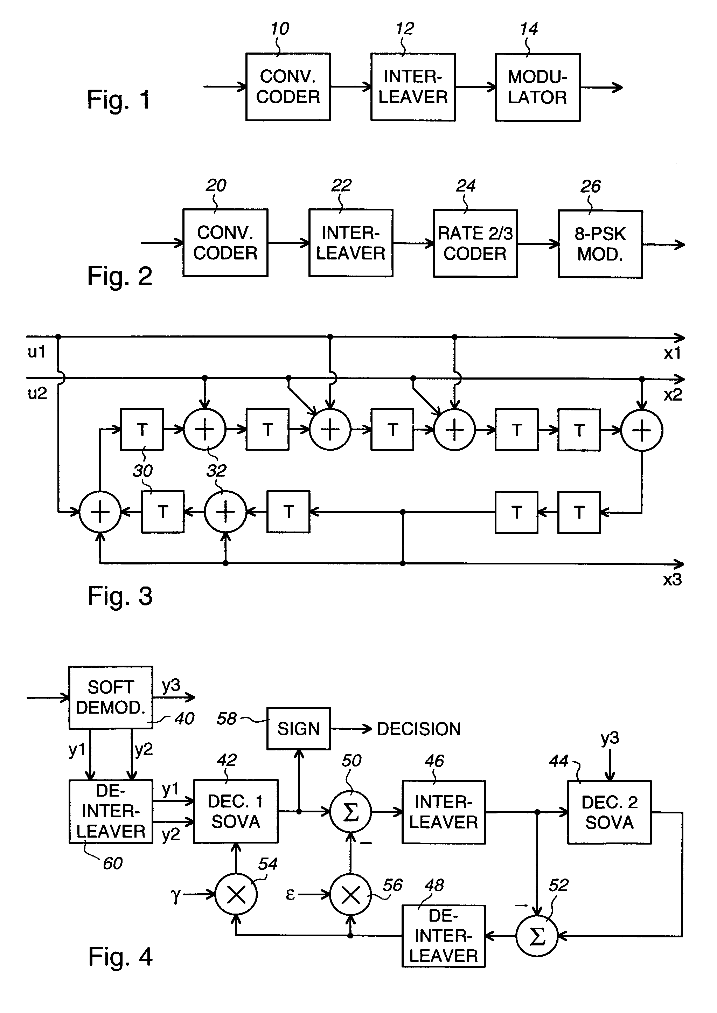

Referring to Fig. 1, a known encoding and modulation arrangement at a transmitter of a communications system comprises a convolutional coder 10 which is supplied with information to be transmitted, a block interleaver 12 to which the coded output of the coder 10 is supplied, and a modulator 14 to which the output of the interleaver 12 is supplied and whose output is supplied to a communications channel. For example, the modulator 14 may be a BPSK, QPSK, or DQPSK modulator.

Assuming that the coder 10 is not a parallel concatenated convolutional (turbo) coder, an arrangement such as that of Fig. 1 can not implement turbo coding because the modulator 14 provides no redundancy, i.e. it provides one modulation bit for each coded information bit supplied to it. Thus even though iterative decoding may be used at a receiver of the communications system for detection and decoding of the received signal, the full advantages of PCCC or turbo coding can not be realized.

Fig. 2 illustrates an encoding and modulating arrangement in accordance with an embodiment of this invention, including a convolutional coder 20 and a block interleaver 22 provided and arranged in the same manner as in the arrangement of Fig. 1. The arrangement of Fig. 2 also includes a systematic coder 24 and a modulator 26, illustrated respectively as a rate 2/3 coder and as an 8-PSK modulator as further described below. The output of the interleaver 22 is supplied to the coder 24, which in this example produces three output bits for every two information bits supplied to its input and hence provides redundancy. As described further below, these three output bits comprise two systematic bits constituted by the respective two information bits supplied to the coder 24, and a third bit which is a parity bit derived by convolutional coding from the two information bits. The output of the coder 24 is supplied to the input of the modulator 26, which in this case produces one modulation symbol for every three bits output from the coder 24, each modulation symbol having one of 8 possible phase states corresponding to the 8 possible combinations of the respective three bits. Thus the coder 24 provides at its output a parallel combination of systematic and parity bits.

In comparison to the arrangement of Fig. 1 in which the modulator 14 is a QPSK or DQPSK modulator having 2 bits per modulation symbol, the rate 2/3 coder 24 and 8-PSK modulator 26 of the arrangement of Fig. 2 provide no change in the overall data rate or signal bandwidth. In comparison to the arrangement of Fig. 1 in which the modulator 14 is a BPSK modulator having 1 bit per modulation symbol, the rate 2/3 coder 24 and 8-PSK modulator 26 of the arrangement of Fig. 2 provide twice the data rate and no change in the signal bandwidth. In both cases the full advantages of turbo (parallel concatenated convolutional) coding are provided, the coding gain more than compensating for the reduced signal point spacing in the 8-PSK signal point constellation in comparison to that of QPSK, DQPSK, or BPSK modulation.

By way of example, the rate 2/3 coder 24 can produce the third bit from the two information bits supplied to its input using a code with a constraint length of K = 9 and Ungerboeck generator polynomials such as g₁ = x⁹ + x² + x + 1, g₂ = x⁶ + x⁵ + x⁴ + x², and g₃ = x⁷ + x⁵ + x⁴ to provide, in conjunction with a decoder as described below, a trellis coding gain of about 5 dB over conventional BPSK modulation in an AWGN (Additive White Gaussian Noise) channel. Fig. 3 illustrates the form of such a coder, but it can be appreciated that other generator polynomials, and other forms of coder 24, can be used.

Referring to Fig. 3, the coder 24 comprises 9 delay elements 30 each providing a delay T of one symbol, and six modulo-2 adders 32 via which the delay elements 30 are interconnected and supplied with the information bits u1 and u2 for each symbol, these information bits being supplied to inputs of the coder from the interleaver 22. The coder produces the three bits x1, x2, and x3 at its outputs, the bits x1 and x2 being systematic bits constituted directly by the input information bits u1 and u2 respectively, and the bit x3 being the parity bit generated by the operation of the coder. Thus it can be seen that the parity bit x3 is provided redundantly in parallel with the systematic bits x1 and x2, thereby providing a parallel output of systematic and parity bits in the manner of a PCCC encoder. The polynomials given above can be expressed in binary form as g₃ = [0 0 1 0 1 1 0 0 0], in accordance with which the information bit u1 = x1 is supplied to the modulo-2 adders 32 at the inputs of the respective delay elements 30 of the coder, g₂ = [0 0 0 1 1 1 0 1 0], in accordance with which the information bit u2 = x2 is supplied to the delay elements 30 in similar manner, and g₁ = [1 0 0 0 0 0 0 1 1 1], in accordance with which the third output bit x3 is fed back to the delay elements 30 of the coder, the connection order being reversed because this is a feedback polynomial.

Fig. 4 illustrates a complementary demodulating and decoding arrangement, which includes a soft demodulator 40 for producing soft decisions y1, y2, and y3 corresponding to the transmitted bits x1, x2, and x3 respectively of each modulation symbol. It can be appreciated that although as described here the modulator 26 is an 8-PSK modulator and the soft demodulator 40 conversely demodulates 8-PSK signals, any other modulation scheme can be used as desired. As can be appreciated, the soft decisions y1 and y2 correspond to the systematic bits and the soft decision y3 corresponds to the parity bit for each modulation symbol. As is well known, each soft decision for a respective bit is a probability that the bit is a binary 0 or 1, or a ratio of such probabilities or a maximum likelihood ratio.

The soft decisions y1, y2, and y3 are supplied to an iterative decoder arrangement which comprises a first decoder (DEC. 1) 42 and a second decoder (DEC. 2) 44, an interleaver 46 that operates in the same manner as the interleaver 22, complementary deinterleavers 48 and 60, summing functions 50 and 52, optional weighting functions 54 and 56, and a sign function 58 which acts as a threshold comparator to produce output decisions from the decoder arrangement.

The first decoder 42 is a trellis decoder which operates in known manner to provide at its output soft decoding decisions of the convolutional code provided by the coder 20. The second decoder 44 is also a trellis decoder which operates to provide at its output soft decoding decisions of the Ungerboeck polynomial code provided by the coder 24 as described above. By way of example, each decoder is illustrated in Fig. 4 as being a SOVA decoder using the Soft-Output Viterbi Algorithm. Alternatively, each decoder may perform maximal *a posteriori* probability (MAP) decoding in accordance with a so-called BCJR algorithm known for example from an article by L. R. Bahl et al. entitled "Optimal Decoding of Linear Codes for Minimizing Symbol Error Rate", IEEE Transactions on Information Theory, vol. IT-20, pages 248-287, March 1974, or it may perform maximum MAP (MAX-MAP) decoding which is also known in the art. The decoders operate in an iterative arrangement using feedback as further described below; there is no feedback for the first pass through the decoding arrangement.

The soft decisions y1 and y2, representing the interleaved systematic bits, produced by the demodulator 40 are deinterleaved by the deinterleaver 60 and supplied to the first decoder 42. In the first pass through the decoding arrangement the resulting systematic bit soft decisions produced by the first decoder 42 are supplied unchanged via the summing function 50 to the interleaver 46. These soft decisions are interleaved by the interleaver 46, in the same manner as for the interleaver 22 in the encoding arrangement of Fig. 2, and are supplied to the second decoder 44 which is also supplied directly with the (interleaved) soft decisions y3 from the demodulator 40. The second decoder 44 produces enhanced soft decisions for the interleaved systematic bits by decoding of the parity information y3.

For iterative feedback, soft decisions at the output of the second decoder 44 are supplied to the summing function 52, which subtracts from these soft decisions the soft decision inputs to the second decoder 44 to produce feedback extrinsic information which is supplied to and deinterleaved by the deinterleaver 48. This deinterleaved extrinsic information is supplied via the weighting function 54 to the first decoder 42, and via the weighting function 56 to a subtractive input of the summing function 50, for use in the next iteration to enhance the soft decoding decisions in a similar manner to the known operation of a turbo decoder. The weighting functions 54 and 56 are illustrated as being constituted by multipliers with weighting factors of γ and ε respectively. Each of these weighting factors can be a constant in the range from 0 to 1 (if equal to one the respective weighting function can be omitted) which can be empirically determined, or it can be varied or adapted in dependence upon the decoding processes. The output of the summing function 50 constitutes feed-forward extrinsic information, which serves to enhance the operation of the second decoder 44, again in a similar manner to the known operation of a turbo decoder.

Each pass of information through the decoders 42 and 44 as described above serves to partially correct errors or impairments in the received signals, so that the iterative decoding can provide a substantial error correction if the input signals to the decoders and the extrinsic information are uncorrelated. The extrinsic information is a likelihood or probability function of redundant information introduced by the encoding process, and is explained for example in the article by C. Berrou et al. referred to above.

After a desired number of iterations, or in dependence upon any other desired parameter, the systematic bit soft decisions produced at the output of the first decoder 42 are compared with a threshold to produce a final, hard or binary, decision for each information bit. Conveniently the soft decisions are numbers whose magnitude represents probability and whose sign represents whether this probability refers to a 0 or 1 bit, in which case as illustrated in Fig. 4 the threshold comparator is constituted by the sign function 58.

It can be appreciated that rearrangements of the two decoders, interleaver, and deinterleavers in the demodulating and decoding arrangement of Fig. 4 may be provided to achieve substantially the same decoding results.

Although the functions of the arrangements of Figs. 2 and 4 are represented as separate units, it should be appreciated that these functions can be implemented by functions of one or more digital signal processors (DSPs) and/or application specific integrated circuits (ASICs).

Although a specific embodiment of the invention has been described above, it can be appreciated that numerous modifications, variations, adaptations and combinations of the aspects thereof may be made within the scope of the invention as defined in the claims.

## Claims

1. A method of encoding information comprising the steps of:
encoding (20) the information in a first coder to produce encoded information; and
interleaving (22) blocks of the encoded information to produce interleaved encoded information; characterized by:
encoding (24) the interleaved encoded information in a second coder to produce further encoded information comprising systematic information (x1, x2), corresponding to the interleaved encoded information (u1, u2), and parity information (x3) produced by the second coder in response to the interleaved encoded information.

2. A method as claimed in claim 1 wherein the encoding in the first coder comprises convolutional encoding.

3. A method as claimed in claim 1 or 2 wherein the parity information is produced by the second coder using Ungerboeck generator polynomials.

4. A method as claimed in claim 1, 2, or 3 wherein the encoding by the second coder produces one additional parity bit for every two bits of the interleaved encoded information, constituting said systematic information.

5. A method as claimed in any of claims 1 to 4 and including the step of modulating the systematic and parity information produced by the second coder.

6. A method as claimed in claims 4 and 5 wherein the step of modulating comprises 8-PSK (phase shift keying) modulation, each modulation symbol comprising said one parity bit and two bits constituting said systematic information.

7. Encoding apparatus comprising:
a first coder (20) for encoding information to produce encoded information; and
an interleaver (22), having an input coupled to an output of the first coder, for interleaving blocks of the encoded information to produce interleaved encoded information; characterized by:
a second coder (24), having an input coupled to an output of the interleaver, for encoding the interleaved encoded information to produce further encoded information comprising systematic information (x1, x2) constituted by the interleaved encoded information (u1, u2) and parity information (x3) produced by the second coder in response to the interleaved encoded information.

8. Apparatus as claimed in claim 7 wherein the first coder comprises a convolutional coder.

9. Apparatus as claimed in claim 7 or 8 wherein the second coder comprises a convolutional coder using Ungerboeck generator polynomials to produce said parity information.

10. Apparatus as claimed in claim 7, 8, or 9 wherein the second coder is a rate 2/3 coder producing one parity bit for every two bits of systematic information.

11. Apparatus as claimed in any of claims 7 to 10 and including a modulator, having an input coupled to an output of the second coder, for modulating the systematic and parity information produced by the second coder.

12. Apparatus as claimed in claims 10 and 11 wherein the modulator is an 8-PSK (phase shift keying) modulator.

13. Decoding apparatus for decoding information encoded by the method of any of claims 1 to 6 or by the encoding apparatus of any of claims 7 to 12, comprising first and second soft decision decoders complementary to the first and second coders, having forward and feedback paths between the decoders for iterative decoding thereby, one of the forward and feedback paths including an interleaver and the other of the forward and feedback paths including a complementary deinterleaver.

14. Apparatus as claimed in any of claims 7 to 13, implemented by functions of a digital signal processor.
